# EUROPÄISCHE PATENTANMELDUNG

(11) **EP 0 718 858 A2**
(43) Veröffentlichungstag der Anmeldung: **26.06.1996**
(21) Anmeldenummer: 95119528.8
(22) Anmeldetag: 12.12.1995
(51) Int. Cl.: H01G 9/20

(54) **Verwendung von organischen Materialien hoher nichtionischer Ladungsträgerbeweglichkeit**

(30) Priorität: 20.12.1994 DE 4445584
(71) Anmelder: BASF AKTIENGESELLSCHAFT, D-67056 Ludwigshafen (DE)
(72) Erfinder: Häussling, Lukas, Dr., D-67098 Bad Dürkheim (DE); Etzbach, Karl-Heinz, Dr., D-67227 Frankenthal (DE); Siemensmeyer, Karl, Dr., D-67227 Frankenthal (DE); Paulus, Wolfgang, Dr., D-67256 Weisenheim (DE); Meissner, Dieter, Dr., D-52428 Jülich (DE); Antonius, Christina, D-30451 Hannover (DE); Engel, Karsten, Dr., D-28717 Bremen (DE); Haarer, Dietrich, Prof. Dr., D-95448 Bayreuth (DE); Kumar, Sundeep, Dr., D-55122 Mainz (DE); Schuhmacher, Peter, D-55127 Mainz (DE)

(57) **Zusammenfassung**

Die Erfindung betrifft die Verwendung von organischen Materialien mit einer spezifischen Leitfähigkeit kleiner 10⁻² S/cm und mit einer nichtionischen Ladungsträgerbeweglichkeit von größer als 10⁻⁴ cm²/Vs als Ladungstransportmedium, mit der Maßgabe, daß in diesem organischen Material durch Lichtabsorption keine Erhöhung der Ladungsträgerkonzentration um den Faktor 10 oder mehr herbeigeführt wird, sowie entsprechende elektrochemische Zellen.

## Beschreibung

Die Erfindung betrifft die Verwendung von organischen Materialien niedriger elektrischer Leitfähigkeit aber hoher nichtionischer Ladungsträgerbeweglichkeit als Ladungstransportmedium.

In der EP-A-0 527 376 werden niedermolekulare und polymere organische Photoleiter mit allgemein diskotischen flüssigkristallinen Eigenschaften mit erhöhter Photoleitfähigkeit beschrie-ben. Ein typischer Vertreter ist das Hexaalkoxytriphenylen, das Ladungsträgerbeweglichkeiten von nahezu 10⁻³ cm²/Vs besitzt (vgl. D. Adam, F. Closs, T. Frey, D. Funhoff, D. Haarer, H. Ringsdorf, R. Schuhmacher, K. Siemensmeyer, Phys. Rev. Lett., 1993, 70 457).

In dem Artikel "Functionalized Porphyrin Discotic Liquid Crystals: Photoinduced Charge Separation and Trapping" von Marye Anne Fox, Allen J. Bard, Horng-Long Pan und Chong-Yang Liu in Journal of the Chinese Chemical Society, 1993, Band 40, Seiten 321-327, wird beschrieben, daß einzelne Mitglieder einer Famile von hochabsorbierenden Porphyrinen, welche symmetrisch angeordnete flexible Seitengruppen aufweisen, bei moderaten Temperaturen diskotische flüssigkristalline Mesophasen bilden. Die Ordnung dieser Phase wird aufrecht erhalten, wenn eine Schicht dieses Materials auf Raumtemperatur abgekühlt wird. Wenn solche Filme in Anwesenheit oder Abwesenheit eines elektrischen Feldes sichtbarer Strahlung ausgesetzt werden, treten photovoltaische Effekte auf.

In "Synthetic Design of Liquid Crystals for Directional Electron Transport" von Marye Anne Fox und Horng-Long Pan in Photochemical Processes in Organized Molecular Systems, 1991, Seiten 359-376, wird die Herstellung einer Festkörper-Photovoltaik-Zelle beschrieben, welche aus einem dünnen Film eines organischen Halbleiters besteht, welcher zwischen Indium-Zinn-Oxid-Elektroden angeordnet ist.

In den vorgenannten Fällen ist eine durch Lichtabsorption erzielte Erhöhung der Ladungsträgerkonzentration zur Erzielung einer ausreichenden Leitfähigkeit erforderlich.

In der WO-A-94/05045 sind Heterokontakte aus konjugierten Polymeren und Akzeptoren, Dioden, Photodioden und photovoltaische Zellen beschrieben, wobei z.B. Fullerene, insbesondere Buckminsterfullerene, C₆₀, eingesetzt werden.

In der deutschen Patentanmeldung P 43 39 711.5 sind neue Triphenylenverbindungen und Verfahren zur Herstellung von diskotisch flüssig-kristallinen vernetzten Polymeren beschrieben.

Als Ladungstransportmedium in elektrochemischen Zellen wurde bisher der Ladungstransport von sich bewegenden Ionen übernommen, die eine ausreichende Diffusionsgeschwindigkeit besitzen müssen. In elektronischen Bauteilen wurden bisher als Ladungstransportmedien anorganische Halbleiter oder organische Polymere oder Oligomere eingesetzt, die eine durch Dotieren oder Lichtanregung ausreichend hohe Ladungsträgerkonzentration besitzen. Die einzigen für praktische Anwendungen interessanten Bauelemente mit einem Ladungstransportmedium mit niedriger Leitfähigkeit sind photovoltaische Zellen, in denen intrinsische anorganische oder organische Halbleiter direkt durch Lichtanregung leitfähig gemacht werden, oder in denen ein anorganischer hochohmiger Halbleiter zum Ladungstransport nach Farbstoffsensibilisierung eingesetzt wird. Hochohmige organische Materialien, die alleine den Ladungstransport übernehmen, sind bisher nicht bekannt.

Aufgabe der Erfindung war es daher, organische Materialien bereitzustellen, welche die vorstehend geschilderten Nachteile nicht aufweisen.

Demgemäß wurde die Verwendung von organischen Materialien mit einer spezifischen Leitfähigkeit kleiner 10⁻² S/cm und mit einer nichtionischen Ladungsträgerbeweglichkeit von größer als 10⁻⁴ cm²/Vs als Ladungstransportmedium, mit der Maßgabe, daß in diesem organischen Material durch Lichtabsorption keine Erhöhung der Ladungsträgerkonzentration um den Faktor 10 oder mehr herbeigeführt wird, gefunden.

Gegenstand der Erfindung sind außerdem elektrochemische Zellen mit mindestens einem Ladungstransportmedium und mindestens zwei Elektroden, worin das Ladungstransportmedium ein organisches Material enthält oder aus diesem besteht, welches eine spezifische Leitfähigkeit kleiner 10⁻² S/cm und eine nicht ionische Ladungsträgerbeweglichkeit von größer als 10⁻⁴ cm²/Vs hat, wobei elektrochemische Zellen, die Hexapentyloxytriphenylen oder Hexahexylthiotriphenylen als Ladungstransportmedium und elektrisch leitfähig beschichtete transparente Glasplatten als Elektroden enthalten, ausgenommen sind.

Die erfindungsgemäße Verwendung von organischen Materialien mit einer spezifischen Leitfähigkeit kleiner 10⁻² S/cm und mit einer nichtionischen Ladungsträgerbeweglichkeit größer als 10⁻⁴cm²/Vs als Ladungstransportmedium umfaßt im allgemeinen den Elektrolytersatz in elektrochemischen Systemen (z.B. Stromspeichersystemen) und insbesondere als Ladungstransportmedium in elektrochemischen Zellen oder elektronischen Bauelementen.

Besonders bevorzugt ist die Verwendung in photoelektrochemischen Zellen. Hierbei sind insbesondere photoelektrochemische Zellen zu nennen, welche zwei Isolatoren enthalten, zwischen denen ein Farbstoffmolekül eingebettet ist. Die Isolatoren besitzen energetische Zustände, die den Transport von Ladungen ermöglichen, auf der einen Seite von Elektronen in unbesetzten Zuständen, auf der anderen Seite von Löchern in besetzten elektronischen Energiezuständen.

Die Elektroden bzw. Kontaktmaterialien bestehen im allgemeinen aus Metallen, Halbmetallen oder Halbleitern, deren Energiezustände und Austrittsarbeiten eine Ladungsübertragung in die zum Transport von den erfindungsgemäßen Ladungstransportmedien bereitgestellten Energiezustände ermöglichen. Die hierbei gebildeten Kontakte können je nach ihrem Anwendungsziel ihrem Strom-Spannungsverhalten nach ohmisch oder gleichrichtend sein. Durch die Kontaktierung entstehen Heterokontakte.

Erfindungsgemäß bevorzugt besitzt eine Elektrode (im allgemeinen die Halbleiterelektrode) eine nanokristalline oder fraktale Oberfläche, wie sie vorzugsweise mit Hilfe von Sol/Gel-Verfahren hergestellt werden (z.B. sogenanntes "rauhes TiO₂").

In einer bevorzugten Ausführungsform der Erfindung werden die organischen Materialien mit einer spezifischen Leitfähigkeit kleiner 10⁻² S/cm und mit einer nichtionischen Ladungsträgerbeweglichkeit von größer als 10⁻⁴ cm⁴/Vs als Ladungstransportmedium für Ladungsträger, die durch Belichten eines Farbstoffes (in sogenannten Sensibilisierungs-Solarzellen, wie sie z.B. in der DE-A-42 07 659 beschrieben sind) oder eines anorganischen gleichrichtenden Kontaktes (in der Festkörper-Photovoltaik) gebildet wurden, verwendet.

Demgemäß sind erfindungsgemäß elektrochemische Zellen bevorzugt, bei denen mindestens eine der Elektroden aus einem gleichrichtenden Halbleiter besteht und/oder mit einem Farbstoff beschichtet ist.

Indium-Zinn-Oxid, mit dem häufig Glasplatten elektrisch leitfähig beschichtet werden, ist demgegenüber ein entarteter Halbleiter, der über keine gleichrichtenden Eigenschaften verfügt.

Elektrochemische Zellen im Sinne der Erfindung sind dabei z.B. Batterien oder Akkumulatoren, Brennstoffzellen, Elektrolyseure und galvanische Zellen.

Elektronische Bauteile im Sinne der Erfindung sind im weitesten Sinne solche Bauteile der Elektronik, Optoelektronik und/oder molekularen Informationsspeicherung und -aufzeichnung, in welchen erfindungsgemäß organische Verbindungen mit einer spezifischen Leitfähigkeit kleiner 10⁻² S/cm und mit einer nichtionischen Ladungsträgerbeweglichkeit größer 10⁻⁴ cm²/Vs als Kontakt- und Fenstermaterial für Heterokontakte, Metallersatz in Schottkykontakten, p- bzw. n-halbleitendes Material oder als organischer Elektrolytersatz eingesetzt werden.

Erfindungsgemäß wird insbesondere ein organisches Material mit flüssigkristallinen Eigenschaften eingesetzt. Geeignet sind neben den kalamitischen flüssigkristallinen Verbindungen insbesondere diskotisch flüssigkristalline Verbindungen.

Bevorzugt werden organische Materialien mit flüssigkristallinen Eigenschaften aus der Gruppe bestehend aus gegebenenfalls substitutierten Triphenylenen, Phthalocyaninen, hexasubstituierten Benzolen, Truxenen, hexa- oder oktasubstituierten Dibenzopyrenen und Oligothiophenen verwendet.

Besonders bevorzugt hiervon sind alkoxy- oder thioalkylsubstituierte Triphenylene oder deren Mischungen, Phthalocyanine, hexasubstituierte Benzole, Truxene und hexa- oder oktasubstituierte Dibenzopyrene, insbesondere alkoxy- oder thioalkylsubstituierte Triphenylene oder deren Mischungen und hexa- oder oktasubstituierte Dibenzopyrane.

In einer besonders bevorzugten Ausführungsform der Erfindung werden alkoxy- oder thioalkylsubstituierte Triphenylene oder deren Mischungen eingesetzt. In einer ganz besonders bevorzugten Ausführungsform werden alkoxylierte Triphenylene eingesetzt.

Diese organischen Materialien sind an sich bekannt (vgl. die deutsche Patentanmeldung P 43 39 711.5 sowie EP-A-0 527 376 und die darin zitierte Literatur).

Die erfindungsgemäße Verwendung erfolgt in der Regel in Form von dünnen Schichten mit einer Schichtdicke von 10⁻⁹ bis 10⁻³ m. Die Schichten werden vorzugsweise aufgedampft, durch Spincoating, Aufrakeln, Aufstreichen oder Siebdruck aufgebracht oder sie werden durch Aufschmelzen beispielsweise in eine Zellanordnung eingebracht. Zur Erzielung der gewünschten Ladungsträgerbeweglichkeiten wird in der Regel eine Orientierung der Moleküle bei einer Temperatur oberhalb der Raumtemperatur vorgenommen, die dann durch langsames Abkühlen bis zur Arbeitstemperatur erhalten bleiben soll. Die Orientierung der Moleküle stellt dann durch geeignete Überlappung von Energiezuständen Leitungswege für Ladungsträger zur Verfügung, in denen diese dann eine ausreichende Beweglichkeit von vorzugsweise oberhalb von 10⁻³ cm²/Vs besitzen.

Die für den Ladungsträgertransport notwendigen Ladungsträger selbst werden dann im allgemeinen mindestens teilweise von den Kontaktmaterialien in das Material injiziert und bewirken eine verbesserte Leitfähigkeit des organischen Materials.

In einer bevorzugten Ausführungsform der erfindungsgemäßen elektrochemischen Zelle besteht der Elektrolyt aus dem organischen Material mit einer spezifischen Leitfähigkeit kleiner 10⁻² S/cm und mit einer nichtionischen Ladungsträgerbeweglichkeit von größer als 10⁻⁴ cm²/Vs.

Dem Ladungstransportmedium können weitere Verbindungen oder Elemente zugemischt sein, die eine weitere Funktionalisierung des organischen Materials selbst erlauben. Hierzu zählt insbesondere auch die Sensibilisierung durch lichtabsorbierende Substanzen, das Dotieren mit Elektronenakzeptoren oder -donatoren oder das Zugeben von reaktiven Verbindungen, deren Eigenschaften das Ladungstransportmedium für Substanzen sensibilisieren, die in einer beabsichtigten Sensorwirkung detektiert und vermessen werden sollen.

Die Erfindung hat zahlreiche Vorteile. Bei der erfindungsgemäßen Verwendung ist die Erzeugung von Ladungsträgern durch Ladungsträgergeneration bei Absorption von Licht (Photoionisation) nicht unbedingt notwendig. Zudem ist eine sehr einfache Kontaktherstellung möglich. Dies geht prinzipiell bei niedrigen Temperaturen. Die Passivierung von Oberflächen ist einfach und die Entstehung von Defekten beim Kontaktieren wird vermieden. Außerdem treten in der Regel keine Rekombinationsverluste mit Ladungsträgern im jeweils anderen Band auf. Daneben kann eine Selbstorientierung unter Anpassung an nicht-ebene Oberflächen erfolgen.

Mit der Verwendung organischer Verbindungen ist außerdem eine große Variabilität in der Erzeugung verschiedener Bandlagen verbunden, die eine gezielte Optimierung der Überlappung von Energiezuständen an Grenzflächen und Kontakten erlaubt. Damit kann auch eine Anpassung von Orbitallagen von Ladungsträger-generierenden und -transportierenden Medien erfolgen.

Bei der erfindungsgemäßen Verwendung als Ladungstransportmedium zum Ersatz von z.B. ionischen Elektrolyten kann die Verwendung technisch schwierig handhabbarer Flüssigkeiten vermieden werden. Es muß außerdem nicht nach ionenbildenden Salzen gesucht werden, die eine ausreichende Löslichkeit in dem Elektrolyten besitzen, selbst aber nicht an der Ladungsübertragung beteiligt sind. Auch auf die Verwendung von Redoxsystemen, die den Ladungstransfer an den Elektroden sicherstellen, kann je nach Anwendung vollständig oder teilweise verzichtet werden.

Weiterhin kann eine durch Phasenumwandlungen auftretende Änderung der Ladungsträgerbeweglichkeit bei festgelegten Temperaturen für Schaltprozesse ausgenutzt werden.

Die erfindungsgemäßen organischen Materialien besitzen weiterhin den Vorteil der chemisch und physikalisch außerordentlich großen Variabilität, die eine gezielte Synthese hinsichtlich der jeweils notwendigen Eigenschaften erlaubt. Außerdem haben sie den Vorteil, daß durch gezielten Einsatz ihrer verschiedenen Phasenzustände (kristallin, flüssigkristallin, flüssig und gasförmig), bei denen ihre Zusammensetzung unverändert bleiben kann, ein sehr einfacher Aufbau elektrochemischer Zellen und der Einsatz niedriger Herstellungstemperaturen und kostengünstiger Verfahren möglich ist. Als Ladungstransportmedium (auch Elektrolyt genannt) werden dagegen bisher nur ionenleitende Materialien eingesetzt. Die erfindungsgemäßen organischen Materialien können auf Grund ihrer hohen Ladungsträgerbeweglichkeit Ladungen auch in nichtionischer Form von Kontaktmaterialien oder Elektroden wegtransportieren, ohne daß sie selber intrinsisch, durch Dotieren oder nach Lichtanregung eine hohe Ladungsträgerkonzentration besitzen müssen. Damit können nun Materialien eingesetzt werden, die ohne von außen injizierte Ladungen hohe Widerstände besitzen.

Die folgenden Beispiele erläutern die Erfindung

### Beispiele

### Beispiel 1

### Anorganisch/organische Solarzelle

Eine Anordnung aus n-GaAs und einer Kontaktelektrode aus ITO-Glas oder metallbedampftem Glas, die durch eine Abstandsfolie räumlich getrennt sind, wurde mittels eines Klebstoffes (Torr-Seal^{R}, Varian) fixiert und auf drei Seiten abgedichtet. Das flüssigkristalline Hexapentyloxytriphenylen (HPT) wurde in Pulverform an der offenen Seite aufgebracht. Zur Herstellung des Ladungstransportmediums wurde die Anordnung bis zum Schmelzpunkt des HPT aufgeheizt. Dabei floß das HPT in den Spalt zwischen den beiden Elektroden. Beim Abkühlen durchlief das HPT die flüssigkristalline Phase. HPT hat eine spezifische Leitfähigkeit kleiner 10⁻⁵ S/cm und eine nichtionische Ladungsträgerbeweglichkeit von 10⁻³ cm²/Vs.

Beim Belichten der Anordnung wurden Ladungsträger im anorganischen n-leitenden Halbleitermaterial erzeugt und in diesem Material getrennt. Die an die Grenzfläche zum organischen Ladungstransportmedium gelangenden Löcher wurden in dieses injiziert und von diesem zum Gegenkontakt, dem ITO-Glas, transportiert. Beim Belichten mit dem Licht einer 450 W-Xenon-Lampe wurde eine Photospannung (U_{OC}) zwischen den beiden Elektroden aufgebaut, wie dies auch bei Verwendung eines flüssigen ionenleitenden Elektrolyten an Stelle des organischen Ladungstransportmediums erwartet worden wäre. Dies war auch der Fall, wenn eine direkte Lichtabsorption des HPT durch Verwendung eines 400 nm-Kantenfilters (UV-Filter) verhindert wurde. Repräsentative Ergebnisse sind in der Tabelle 1 aufgeführt. Wenn die beiden Elektroden verbunden wurden, resultierte der in der Tabelle 2 angegebene Photostrom. Die in den Tabellen 1 und 2 aufgeführten Ergebnisse zeigen, daß die Photospannung mit dem Logarithmus der Lichtintensität und der Photostrom linear mit der Lichtintensität anstieg.

Die Leistungscharakteristik der photovoltaischen Zelle ist in der Tabelle 3 aufgeführt. Es ergab sich eine für photovoltaische Zellen typische Leistungscharakteristik mit einem Punkt maximaler Leistung (MPP), der in der nicht optimierten Anordnung schon bei etwa 75 % der Leerlaufspannung und etwa 40 % des Kurzschlußstromes lag.

Die Temperaturabhängigkeit der in der Zelle gemessenen Kurzschluß-Photoströme ist in der Tabelle 4 dargestellt. Diese Temperaturabhängigkeit widerspiegelt den Einfluß der Molekülorientierung und damit der Überlappung der den Stromtransport übernehmenden Energiezustände des höchsten besetzten Molekülniveaus. Ein deutlicher Anstieg des Photostromes war beim Übergang in die flüssigkristalline Phase des HPT zwischen 60 und 90°C zu sehen.

**Tabelle 1**

| Lichtintensität/a.u. | Photospannung / mV |
|---|---|
| 100 | 690 |
| 10 | 520 |
| 0.1 | 380 |

**Tabelle 2**

| Lichtintensität/a.u. | Photostrom/nA | Photostrom / nA mit UV-Filter (400nm) |
|---|---|---|
| 0.01 | 7.9 | 1.75 |
| 0.1 | 47.5 | 2.9 |
| 0.2512 | 105 | 4.15 |
| 0.5012 | 180 | 6.0 |
| 1 | 324-390 | 17.8 |

**Tabelle 3**

| abgegriffene Spannung/V | genutzter Photostrom/nA | erzeugte Leistung / nW |
|---|---|---|
| 0 | 382 | 0 |
| -50 | 319 | 15.95 |
| -100 | 274 | 27.4 |
| -150 | 241 | 36.15 |
| -200 | 217 | 43.4 |
| -300 | 183 | 54.9 |
| -400 | 152 | 60.8 |
| -500 | 96 | 48.0 |
| -592 | 0 | 0 |

**Tabelle 4**

| Temperatur/°C | Photostrom / nA |
|---|---|
| 37 | 3.4 |
| 42 | 5.5 |
| 48 | 9.5 |
| 55 | 16.8 |
| 62.5 | 100 |
| 69 | 230 |
| 76 | 295 |
| 93 | 411 |
| 107 | 460 |

### Beispiel 2

### Sensibilisierungs-Solarzelle

Auf einer TiO₂-Oberfläche wurde durch Eintauchen in eine Lösung eines derivatisierten Ruthenium-tris(bipyridyl)-Farbstoffs dieser. Farbstoff gebunden. Diese Elektrode wurde dann wie unter Beispiel 1 beschrieben mit einer HPT-Schicht kontaktiert. In der Tabelle 5 sind die durch Einsatz von Interferenzfiltern bei verschiedenen Wellenlängen gemessenen Photoströme aufgeführt.

Die gemessenen Werte wurden der einfacheren Vergleichbarkeit halber auf die höchsten Werte normiert. Das spektrale Verhalten des Photostromes "reproduzierte" das Spektrum des angeregten Farbstoffes. Die absoluten Photoströme betrugen größenordnungsmäßig 1 nA.

Bezogen auf das eingestrahlte Licht, das von der aktiven Farbstoffmonolage nur zu weniger als 1 % absorbiert werden konnte, entspricht dies einer scheinbaren Quantenausbeute von etwa 0,3 %.

### Beispiel 3

Analog zu Beispiel 2 wurde eine Solarzelle aufgebaut, jedoch wurde die auf der ITO-Elektrode befindliche TiO₂-Kontaktschicht nach dem Sol-Gel-Verfahren als kolloides TiO₂ durch mehrfaches Tauchen auf die ITO-Elektrode aufgebracht. Auf diese Weise wurden vollständig sperrende Kennlinien ab einer Anzahl von 3 bis 4 Lagen gemessen. Die Solarzelle mit kolloidem TiO₂-Kontakt zeigte über einige Stunden bessere Photoströme bei Beleuchtung mit Weißlicht als die Zelle mit kristallinem TiO₂-Kontakt.

### Vergleichsbeispiel

Es wurde gearbeitet wie unter Beispiel 2 beschrieben, nur daß statt der HPT-Schicht als Elektrolyt eine Jodid-Lösung (0,5 M bei pH 2,5, eingestellt mit HClO₄) verwendet wurde. Die gemessenen Photoströme sowie die Quantenausbeute sind in der Tabelle 5 aufgeführt, wobei die gemessenen Werte der einfacheren Vergleichbarkeit halber auf die höchsten Werte normiert wurden. Die absoluten monochromatischen Photoströme betrugen größenordnungsmäßig 1 nA. Das spektrale Verhalten des Photostromes "reproduzierte" das Spektrum des Farbstoffes.

Die Ergebnisse in Tabelle 5 belegen, daß ein flüssiger ionen-leitender Elektrolyt, in dem sich für photovoltaische Anwendungen außerdem noch ein Redoxsystem befinden kann, vollständig durch das erfindungsgemäße Ladungstransportmedium ersetzt werden kann.

Die erreichten Photospannungen von einigen hundert mV waren ebenfalls vergleichbar.

**Tabelle 5**

| Wellenlänge /nm | Quantenausbeute | Photostrom /a. u. | Photostrom / a. u. |
|---|---|---|---|
| 450 | 100 | 100 | 100 |
| 525 | 103 | 96 | 95 |
| 550 | 79 | 52 | 75 |
| 600 | 31 | 35 | 60 |
| 700 | 3 | 0 | 30 |

## Patentansprüche

1. Verwendung von organischen Materialien mit einer spezifischen Leitfähigkeit kleiner 10⁻² S/cm und mit einer nichtionischen Ladungsträgerbeweglichkeit von größer als 10⁻⁴ cm²/Vs als Ladungstransportmedium, mit der Maßgabe, daß in diesem organischen Material durch Lichtabsorption keine Erhöhung der Ladungsträgerkonzentration um den Faktor 10 oder mehr herbeigeführt wird.

2. Verwendung nach Anspruch 1, dadurch gekennzeichnet, daß das organische Material flüssigkristalline Eigenschaften aufweist.

3. Verwendung nach Anspruch 2, dadurch gekennzeichnet, daß das organische Material mit flüssigkristallinen Eigenschaften ausgewählt ist aus der Gruppe bestehend aus gegebenenfalls substitutierten Triphenylenen, Phthalocyaninen, hexasubstituierten Benzolen, Truxenen, hexa- oder oktasubstituierten Dibenzopyrenen und Oligothiophenen.

4. Verwendung nach einem der Ansprüche 1 bis 3, dadurch gekennzeichnet, daß die Verwendung als Ladungstransportmedium in elektrochemischen Zellen oder in elektronischen Bauelementen erfolgt.

5. Verwendung nach Anspruch 4 in photoelektrochemischen Zellen.

6. Elektrochemische Zellen mit mindestens einem Ladungstransportmedium und mindestens zwei Elektroden, dadurch gekennzeichnet, daß der das Ladungstransportmedium bildende Elektrolyt ein organisches Material enthält oder aus diesem besteht, welches eine spezifische Leitfähigkeit kleiner 10⁻² S/cm und eine nichtionische Ladungsträgerbeweglichkeit von größer als 10⁻⁴ cm²/Vs hat, wobei elektrochemische Zellen, die Hexapentyloxytriphenylen oder Hexahexylthiotriphenylen als Ladungstransportmedium und elektrisch leitfähig beschichtete transparente Glasplatten als Elektroden enthalten, ausgenommen sind.

7. Elektrochemische Zellen nach Anspruch 6, dadurch gekennzeichnet daß der Elektrolyt aus dem organischen Material besteht.

8. Elektrochemische Zellen nach Anspruch 6 oder 7, dadurch gekennzeichnet, daß das organische Material flüssigkristalline Eigenschaften hat.

9. Elektrochemische Zellen nach Anspruch 8, dadurch gekennzeichnet, daß das organische Material mit flüssigkristallinen Eigenschaften ausgewählt ist aus der Gruppe bestehend aus gegebenenfalls substitutierten Triphenylenen, Phthalocyaninen, hexasubstituierten Benzolen, Truxenen, hexa- oder oktasubstituierten Dibenzopyrenen und Oligothiophenen.

10. Elektrochemische Zellen nach Anspruch 9, dadurch gekennzeichnet, daß das organische Material ausgewählt ist aus der Gruppe bestehend aus alkoxy- oder thioalkylsubstituierten Triphenylenen oder deren Mischungen, Phthalocyaninen, hexasubstituierten Benzolen, Truxenen und hexa- oder oktasubstituierten Dibenzopyrenen.

11. Elektrochemische Zellen nach einem der Ansprüche 6 bis 10, dadurch gekennzeichnet, daß mindestens eine der Elektroden aus einem gleichrichtenden Halbleiter besteht und/oder mit einem Farbstoff beschichtet ist.

12. Elektrochemische Zellen nach einem der Ansprüche 6 bis 11, dadurch gekennzeichnet, daß sie photoelektrochemische Zellen sind.
